# FASCICULE DE BREVET EUROPEEN

(11) **EP 0 834 600 B1**
(45) Date de publication et mention de la délivrance du brevet: **08.08.2001**
(21) Numéro de dépôt: 97402224.6
(22) Date de dépôt: 24.09.1997
(51) Int. Cl.: C23C 28/02, C23C 14/20

(54) **Revêtement de surface de matériaux isolants, son procédé d'obtention et son application pour la réalisation de blindages pour boîtiers isolants**
Beschichtung für wärmeisolierende Materialien, Verfahren und Verwendung davon zur Herstellung von Abschirmungen für Isolierstoffgehäuse
Surface coating of insulant materials, process and application for making shielding for insulated cases

(30) Priorité: 26.09.1996 FR 9611724
(43) Date de publication de la demande: 08.04.1998
(73) Titulaire: Tecmachine, 42160 Andrézieux-Bouthéon (FR)
(72) Inventeur: Heau, Christophe, 42100 Saint-Etienne (FR); Berger, Paul, 42490 Fraisses (FR)
(74) Mandataire: CABINET BONNET-THIRION

(56) Documents cités:
- EP-A- 0 140 032
- WO-A-94/18003
- WO-A-94/21099
- DE-A- 4 322 512
- DE-A- 4 443 530
- GB-A- 2 270 421
- PATENT ABSTRACTS OF JAPAN vol. 5, no. 84 (P-064), 2 juin 1981 & JP 56 029837 A (TDK), 25 mars 1981,

## Description

La présente invention concerne un revêtement de surface de matériaux isolants. Plus précisément, l'invention se rapporte à un revêtement de surface destiné à assurer une protection contre les agressions électromagnétiques en ambiance corrosive pour des pièces en matériaux isolants.

Lesdits matériaux isolants sont notamment des matériaux polymères ou des matériaux composites du type comportant par exemple, mais de façon non exclusive, une résine de base en matériau polymère avec des fibres de renfort.

La présente invention a notamment pour application la réalisation d'un blindage électromagnétique pour des boîtiers de composants électriques ou électroniques en matériaux polymères ou en matériaux composites. L'invention concerne donc également de tels boîtiers de composants électriques ou électroniques en matériau polymère ou composite comportant un blindage.

La présente invention a encore pour application la réalisation d'une couche de protection pour des pièces soumises à des sollicitations sévères telles que la corrosion, qui nécessiteront la présence d'une couche métallique de protection présentant une adhérence élevée, quelles que soient les sollicitations extérieures.

On connaît déjà des procédés industriels de métallisation de pièces en matériaux polymères, notamment le procédé dit par voie humide et le procédé dit par évaporation sous vide ou encore l'application de peintures chargées de particules métalliques.

Le procédé par voie humide consiste généralement à faire une préparation appropriée de la surface comportant des étapes de satinage et activation, puis à déposer une couche de cuivre en deux étapes, la première par conversion chimique, la deuxième par électrolyse.

Le procédé par évaporation sous vide, très utilisé dans le domaine de la décoration, consiste à appliquer sur la pièce à revêtir, par évaporation sous vide, un film très mince de métal, généralement de l'aluminium. De par sa faible épaisseur, ce film est très fragile. C'est pourquoi, il est ensuite souvent protégé par un vernis.

Dans certains cas, la métallisation est parfois précédée par un traitement d'activation par un plasma atmosphérique ou sous vide.

Enfin, les peintures conductrices, constituées de résines contenant des particules métalliques, par exemple en cuivre, aluminium, argent, etc., sont parfois utilisées mais elles présentent des résistivités élevées et l'épaisseur du revêtement n'est pas maîtrisée avec une grande précision.

Les progrès techniques et les exigences de performances de plus en plus poussées, font que les solutions actuelles sont à leurs limites et ne peuvent pas être utilisées dans de nombreux cas.

En particulier, les nouvelles applications de l'électronique conduisent à utiliser des appareils portables dans des conditions de plus en plus variées, notamment à l'extérieur des bâtiments, de sorte qu'apparaît une nouvelle contrainte qui est la résistance aux différentes formes de corrosion. En effet, ce phénomène peut entraîner une dégradation, voire une consommation de la couche métallique comme c'est le cas pour l'aluminium et le cuivre, il peut aussi être à l'origine d'une dégradation de l'interface entre le substrat en polymère et le revêtement métallique responsable d'un décollement partiel ou total de ce dernier. Dans les deux cas, la protection électromagnétique des composants n'est plus assurée.

Un objet de la présente invention est de fournir un revêtement de surface qui tout en présentant une excellente adhérence sur les matières plastiques et composites et en faisant preuve d'une remarquable résistance à la corrosion, notamment saline, assure une protection de qualité contre les agressions électromagnétiques et dont l'adhérence n'est pas affectée par l'exposition à une atmosphère corrosive.

La demanderesse a mis au point une composition de revêtement de surface sur un substrat en matériau isolant répondant à l'objet ci-dessus en assurant la pérennité de la protection électromagnétique, même dans des ambiances corrosives.

Pour être conforme à l'invention, le revêtement doit impérativement posséder simultanément les caractéristiques suivantes : il est composé de deux couches superposées, la plus externe, ou superficielle, est à base d'argent métallique ou d'un de ses alliages, la plus profonde, située entre cette dernière et le substrat en matériau isolant, est constituée d'un alliage à base de nickel contenant entre environ 80 et 98 % en poids de nickel et entre environ 2 et 20 % en poids d'au moins un métal du groupe V B de la Classification Périodique des Eléments.

La présente invention fournit donc un revêtement de surface sur un substrat en matériau isolant, destiné à assurer une protection contre les agressions électromagnétiques en ambiance corrosive, constitué d'un empilement de deux couches métalliques, caractérisé en ce que la première des deux dites couches, au contact du substrat, est une couche d'alliage à base de nickel contenant environ 80 à 98 % en poids de nickel et au moins un métal du groupe V B de la Classification Périodique des Eléments dans une teneur comprise entre environ 2 et 20 % en poids, et en ce que la seconde des deux dites couches, superficielle, est une couche à base d'argent métallique ou d'un de ses alliages.

Selon l'invention, l'alliage à base de nickel contient au moins un élément appartenant au groupe V B de la Classification Périodique des Eléments, le plus courant étant le vanadium, dans une teneur comprise entre environ 2 et 20 % en poids. Avantageusement, la teneur de l'alliage à base de nickel en métal du groupe V B de la Classification Périodique des Eléments est comprise entre environ 5 et 10 % en poids.

De façon encore inexpliquée, les propriétés simultanées de protection contre les agressions électromagnétiques, résistance à la corrosion et adhérence, sont optimales lorsque la couche d'alliage à base de nickel et la couche à base d'argent métallique ont des épaisseurs comprises entre respectivement 0,02 et 1 micromètre et 0,2 et 2 micromètres. Ces qualités sont susceptibles de se dégrader si les épaisseurs sont supérieures à celles indiquées. Pour des épaisseurs inférieures, l'adhérence est excellente mais la résistance à la corrosion et la protection électromagnétique sont insuffisantes.

Il est bien connu de l'homme de l'art que les alliages à base d'argent ont une résistivité plus grande que celle de l'argent métallique. Par conséquent, dans le cas d'un alliage à base d'argent, il faut multiplier la valeur de l'épaisseur de la couche par "n", "n" étant la valeur du rapport entre la résistivité dudit alliage à base d'argent et la résistivité de l'argent métallique.

WO-A-94/21099 décrit un procédé de blindage électromagnétique de coffrets en matière plastique consistant à plaquer contre sa surface un produit de type film métallisé.

Cette référence enseigne la fabrication d'un revêtement de surface sur un substrat en matériau isolant consistant en l'empilement de deux couches métalliques.

La résistance à la corrosion de la pièce revêtue n'est pas assurée.

GB-A-2 270 421 décrit un guide d'ondes constitué d'un substrat en polymère recouvert d'une sous-couche de nickel pur, elle-même recouverte d'un métal conducteur.

La protection contre les agressions électromagnétiques en atmosphère corrosive n'est pas assurée.

Le revêtement de surface de la présente invention est particulièrement avantageux et performant car, de façon simultanée :
- il assure une protection de qualité contre les agressions électromagnétiques grâce à une excellente conductibilité électrique,
- il présente une adhérence excellente sur les matières plastiques et composites,
- il présente une excellente résistance à la corrosion, notamment saline,
- son adhérence n'est absolument pas affectée par l'exposition à l'atmosphère corrosive.

Le revêtement de surface bicouche objet de l'invention, peut être mis en oeuvre par n'importe quelles technologies ou procédés de traitement de surface appropriés sans que ses propriétés en soient affectées. Toutefois, selon un mode préférentiel mais non exclusif, le revêtement objet de l'invention sera réalisé par une technologie de dépôt sous vide, les meilleurs résultats étant obtenus par la technique de pulvérisation cathodique.

Les revêtements de surface de la présente invention trouvent une application comme blindage pour des boîtiers de composants électriques ou électroniques, notamment des boîtiers de téléphones portables.

Les Exemples non limitatifs décrits ci-après illustrent l'invention.

### Exemples :

Dans tous les Exemples ci-après, on a revêtu des éprouvettes en polymère. On a procédé d'abord à un test de mesure de résistance électrique superficielle, ou résistance par carré, notée R□ , représentative de la protection contre les agressions électromagnétiques et on a évalué l'adhérence du revêtement grâce au test normalisé d'arrachement par une bande adhésive après quadrillage. Les éprouvettes ont été ensuite soumises 48 h au test de corrosion accéléré dit "du brouillard salin", effectué selon la norme NF C 20-711. Après avoir été lavées et séchées, les éprouvettes ont subi à nouveau le test de mesure de résistance superficielle et d'adhérence, selon le test d'arrachement normalisé NF T 30-038; le résultat final permet d'apprécier le niveau de protection assuré par le revêtement et sa pérennité.

### Exemple 1 (Comparatif)

Sur un lot de 5 éprouvettes, on réalise d'abord une activation par plasma d'oxygène, puis on dépose par évaporation sous vide une couche d'aluminium d'une épaisseur égale à 3 micromètres.

Avant le test de corrosion, la résistance R□ moyenne est de 60 mΩ□, l'adhérence est excellente (aucun arrachement au test de traction). Après exposition au brouillard salin, la résistance R□ est de 150 mΩ□ suivant les points de mesure, ce qui est confirmé par l'observation visuelle : le revêtement est transformé, au moins en surface, en alumine plus ou moins hydratée isolante. Dans le même temps, l'adhérence est devenue très faible, le revêtement s'arrache facilement à la bande adhésive.

### Exemple 2 (Comparatif)

Sur un deuxième lot de 5 éprouvettes, on réalise un dépôt de cuivre d'épaisseur 5 micromètres par une technique classique en phase aqueuse : satinage, activation, précuivrage chimique, cuivrage électrolytique.

Avant le test de corrosion, la résistance R□ moyenne est de 10 mΩ□ et l'adhérence est excellente.

Après exposition au brouillard salin, l'aspect du revêtement montre la présence abondante de vert de gris, la résistance R□ est comprise entre 20 mΩ□ et 80 mΩ□, l'adhérence n'est pas mesurable car le revêtement est en partie décollé et écaillé en de nombreux points des éprouvettes.

### Exemple 3 (Comparatif)

Sur un troisième lot d'éprouvettes, on applique une peinture conductrice référence 599-Y 2000 obtenue auprès de BECKER INDUSTRIE, que l'on polymérise ensuite selon les recommandations du fabricant. L'épaisseur moyenne du film est de 35 ± 10 micromètres.

Avant le test de corrosion, la résistance R□ moyenne est de 50 mΩ□ , l'adhérence est excellente car le test de traction ne révèle aucun point d'arrachement. Après corrosion, l'aspect du revêtement a peu évolué, la résistance R□ est comprise entre 320 et 450 mΩ□. L'adhérence est partiellement altérée car le test montre quelques arrachements.

### Exemple 4

On divise un quatrième lot de 15 éprouvettes en trois groupes A, B et C de 5 éprouvettes chacun. Chaque lot reçoit successivement une première couche d'alliage de nickel comportant 8 % de vanadium (couche au contact du substrat), suivie d'une couche d'argent métallique (couche superficielle), les deux couches étant déposées successivement et par pulvérisation cathodique sous vide.

Les épaisseurs respectives des couches déposées sur les éprouvettes des trois groupes sont décrites dans le Tableau 1 ci-après :

**Tableau 1**

| Groupe | Alliage à base de Ni | Argent métallique |
|---|---|---|
| A | 0,02 µm | 0,2 µm |
| B | 0,1 µm | 0,7 µm |
| C | 0,5 µm | 1,8 µm |

Les résultats des tests de résistance superficielle et d'adhérence avant et après corrosion sont donnés dans le Tableau 2 ci-après:

**Tableau 2**

| | Avant corrosion | | Après corrosion | |
|---|---|---|---|---|
| Groupe | R□ (± 5 mΩ□) | Adhérence | R□ (± 5 mΩ□) | Adhérence |
| A | 260 mΩ□ | pas d'arrachement | 260 mΩ□ | pas d'arrachement |
| B | 80 mΩ□ | pas d'arrachement | 80 mΩ□ | pas d'arrachement |
| C | 35 mΩ□ | quelques points | 35 mΩ□ | quelques points |

On remarque qu'aucune éprouvette des trois groupes n'a changé d'aspect après corrosion, l'adhérence est excellente puisque le test ne révèle aucun point d'arrachement pour les groupes A et B, quelques points d'arrachement seulement pour le groupe C, car l'épaisseur des revêtements, probablement trop forte, n'a pas permis de constituer une interface de qualité parfaite. La résistance R□ est remarquablement stable. Les valeurs très faibles de R□ mesurées pour les groupes B et C sont gages d'un excellent niveau de protection; les valeurs de R□ mesurées pour le groupe A, quoique acceptables, sont d'un niveau de performances légèrement inférieur, vraisemblablement lié à la faible épaisseur des couches.

L'homme de l'art comprendra que bien que l'invention ait été décrite et illustrée pour des modes de réalisation particuliers, de nombreuses variantes peuvent être envisagées tout en restant dans le cadre de l'invention tel que défini dans les revendications annexées.

## Revendications

1. Revêtement de surface sur un substrat en matériau isolant, destiné à assurer une protection contre les agressions électromagnétiques en ambiance corrosive, constitué d'un empilement de deux couches métalliques, caractérisé en ce que la première des deux dites couches, au contact du substrat, est une couche d'alliage à base de nickel contenant environ 80 à 98 % en poids de nickel et au moins un métal du groupe V B de la Classification Périodique des Eléments dans une teneur comprise entre environ 2 et 20 % en poids, et en ce que la seconde des deux dites couches, superficielle, est une couche à base d'argent métallique ou d'un de ses alliages.

2. Revêtement de surface selon la revendication 1, caractérisé en ce que la teneur de l'alliage à base de nickel en élément du groupe V B de la Classification Périodique des Eléments, est comprise entre environ 5 et 10 % en poids.

3. Revêtement de surface selon l'une des revendications 1 et 2, caractérisé en ce que l'élément du groupe V B de la Classification Périodique des Eléments est le vanadium.

4. Revêtement de surface selon l'une quelconque des revendications 1 à 3, caractérisé en ce que l'épaisseur de la couche d'alliage à base de nickel est comprise entre 0,02 et 1 micromètre.

5. Revêtement de surface selon l'une quelconque des revendications 1 à 4 dans lequel la couche superficielle est de l'argent métallique, caractérisé en ce que l'épaisseur de la couche à base dudit argent métallique est comprise entre 0,2 et 2 micromètres.

6. Revêtement de surface selon l'une quelconque des revendications 1 à 4 dans lequel la couche superficielle est un alliage à base d'argent, caractérisé en ce que l'épaisseur de la couche à base d'alliage d'argent est comprise entre n x (0,2 et 2 micromètres), "n" étant la valeur du rapport entre la résistivité dudit alliage à base d'argent et la résistivité de l'argent métallique.

7. Revêtement de surface selon l'une quelconque des revendications 1 à 6, caractérisé en ce que le matériau isolant est choisi parmi les matériaux polymères et les matériaux composites.

8. Revêtement de surface selon la revendication 7, caractérisé en ce que le matériau composite est constitué d'un polymère et de fibres de renfort.

9. Revêtement de surface selon les revendications 1 à 8, caractérisé en ce que les couches d'alliage à base de nickel et la couche superficielle à base d'argent sont réalisées par une technologie de dépôt sous vide.

10. Revêtement de surface selon la revendication 9, caractérisé en ce que la technologie de dépôt sous vide est la pulvérisation cathodique.

11. Boîtier de composants électriques ou électroniques en matériau isolant comportant un blindage, caractérisé en ce que ledit blindage est constitué d'un revêtement de surface selon l'une quelconque des revendications 1 à 10.

## Claims

1. A surface coating on a substrate of insulating material, which is intended to afford protection from electromagnetic attacks in a corrosive environment, formed by a stack of two metal layers, characterised in that the first of the two said layers which is in contact with the substrate is a layer of nickel-base alloy containing about 80 to 98% by weight of nickel and at least one metal of group VB of the periodic classification of elements in an amount of between about 2 and 20% by weight, and that the second of said two layers being a surface layer is a layer based on metal silver or one of its alloys.

2. A surface coating according to claim 1 characterised in that the amount of element of group VB of the periodic classification of elements in the nickel-base alloy is between about 5 and 10% by weight.

3. A surface coating according to one of claims 1 and 2 characterised in that the element of group VB of the periodic classification of elements is vanadium.

4. A surface coating according to any one of claims 1 to 3 characterised in that the thickness of the layer of nickel-base alloy is between 0.02 and 1 micrometer.

5. A surface coating according to any one of claims 1 to 4 wherein the surface layer is of metal silver characterised in that the thickness of the layer based on said metal silver is between 0.2 and 2 micrometers.

6. A surface coating according to any one of claims 1 to 4 wherein the surface layer is a silver-base alloy, characterised in that the thickness of the silver alloy-base layer is between n x (0.2 and 2 micrometers), 'n' being the value of the ratio between the resistivity of the silver-base alloy and the resistivity of the metal silver.

7. A surface coating according to any one of claims 1 to 6 characterised in that the insulating material is selected from polymer materials and composite materials.

8. A surface coating according to claim 7 characterised in that the composite material is formed by a polymer and reinforcing fibres.

9. A surface coating according to claims 1 to 8 characterised in that the nickel-base alloy layers and the silver-base surface layer are produced by vacuum deposition technology.

10. A surface coating according to claim 9 characterised in that the vacuum deposition technology is cathodic sputtering.

11. A casing for electrical or electronic components of insulating material comprising a screening, characterised in that said screening is formed by a surface coating according to any one of claims 1 to 10.

## Patentansprüche

1. Oberflächenbeschichtung auf einem Substrat aus einem isolierenden Material, die dazu bestimmt ist, einen Schutz gegen die elektromagnetischen Angriffe in einem korrosiven Umfeld zu bilden, die aus einem Stapel von zwei metallischen Schichten besteht, dadurch gekennzeichnet, daß die erste der zwei genannten Schichten, das Substrat berührend, eine Schicht aus einer Legierung auf Nickelbasis mit ungefähr 80 bis 98 Gew.-% Nickel und mindestens einem Metall der Gruppe V B des Periodensystems der Elemente mit einem Anteil zwischen ungefähr 2 und 20 Gew.-% ist und daß die zweite der zwei genannten Schichten, die Oberfläche bildend, eine Schicht auf Grundlage von metallischem Silber oder einer seiner Legierungen ist.

2. Oberflächenbeschichtung nach Anspruch 1, dadurch gekennzeichnet, daß der Anteil in der Legierung auf Nickelbasis an Elementen der Gruppe V B des Periodensystems der Elemente zwischen ungefähr 5 und 10 Gew.-% liegt.

3. Oberflächenbeschichtung nach einem der Ansprüche 1 und 2, dadurch gekennzeichnet, daß das Element der Gruppe V B des Periodensystems der Elemente Vanadium ist.

4. Oberflächenbeschichtung nach irgendeinem der Ansprüche 1 bis 3, dadurch gekennzeichnet, daß die Dicke der Schicht aus der Legierung auf Nickelbasis zwischen 0,02 und 1 Mikrometer liegt.

5. Oberflächenbeschichtung nach irgendeinem der Ansprüche 1 bis 4, in der die Oberflächenschicht aus metallischem Silber ist, dadurch gekennzeichnet, daß die Dicke der Schicht auf Basis des genannten metallischen Silbers zwischen 0,2 und 2 Mikrometern liegt.

6. Oberflächenbeschichtung nach irgendeinem der Ansprüche 1 bis 4, in der die Oberflächenschicht eine Legierung auf Silberbasis ist, dadurch gekennzeichnet, daß die Dicke der Schicht auf Grundlage der Silberlegierung zwischen n x (0,2 und 2 Mikrometern) liegt, wobei "n" der Wert des Verhältnisses zwischen dem spezifischen Widerstand der genannten Legierung auf Silberbasis und dem spezifischen Widerstand des metallischen Silbers ist.

7. Oberflächenbeschichtung nach irgendeinem der Ansprüche 1 bis 6, dadurch gekennzeichnet, daß das isolierende Material aus den Polymerwerkstoffen und den Verbundwerkstoffen gewählt ist.

8. Oberflächenbeschichtung nach Anspruch 7, dadurch gekennzeichnet, daß der Verbundwerkstoff aus einem Polymeren und Verstärkungsfasern besteht.

9. Oberflächenbeschichtung nach den Ansprüchen 1 bis 8, dadurch gekennzeichnet, daß die Schichten aus der Legierung auf Nickelbasis und die Oberflächenschicht auf Silberbasis mit einem Vakuumablagerungsverfahren hergestellt werden.

10. Oberflächenbeschichtung nach Anspruch 9, dadurch gekennzeichnet, daß das Vakuumablagerungsverfahren die Kathodenzerstäubung ist.

11. Gehäuse mit elektrischen oder elektronischen Komponenten aus isolierendem Material mit einer Abschirmung, dadurch gekennzeichnet, daß die genannte Abschirmung aus einer Oberflächenbeschichtung nach irgendeinem der Ansprüche 1 bis 10 besteht.
